# EUROPÄISCHE PATENTSCHRIFT

(11) **EP 1 659 837 B1**
(45) Veröffentlichungstag und Bekanntmachung des Hinweises auf die Patenterteilung: **28.11.2007**
(21) Anmeldenummer: 05023091.1
(22) Anmeldetag: 22.10.2005
(51) Int. Cl.: H05K 1/00, H05K 3/32, H01R 9/22, H01R 9/24

(54) **Kontaktierung eines Bauelementes auf einem Stanzgitter**
Contact between a component and a busbar grid
Contact entre un composant et un réseau de barres conductrices

(30) Priorität: 23.11.2004 DE 102004056547; 17.08.2005 DE 102005038813
(43) Veröffentlichungstag der Anmeldung: 24.05.2006
(73) Patentinhaber: Hirschmann Automotive GmbH, 6830 Rankweil-Brederis (AT)
(72) Erfinder: Kreuter, Markus, 6845 Hohenems (AT); Schmid, Martin, 6820 Frastanz (AT)
(74) Vertreter: Thul, Hermann

(56) Entgegenhaltungen:
- EP-A- 0 891 124
- DE-A1- 4 310 369
- US-A- 4 872 262
- US-A1- 2001 006 859

## Beschreibung

Die Erfindung betrifft ein Stanzgitter mit Leitungsbereichen und Kontaktflächen zur elektrischen Kontaktierung von Bauteilen, insbesondere elektronische Bauteilen, gemäß den Merkmalen des Oberbegriffes des Patentanspruches 1.

Elektrische oder elektronische Bauteile zur Realisierung der Funktion eines elektronischen Gerätes werden in bekannter Weise auf Leiterplatten mit darauf befindlichen Leiterbahnen (auch PCB, Printed Circuit Board genannt) bestückt. Daneben ist auch eine Bestückung der Bauteile auf Stanzgitter oder flexible Leiterplatten (FPC, Flexible Printed Circuit) möglich. Die Möglichkeit zur Positionierung auf starren oder flexiblen Leiterplatten oder Stanzgittern ist allerdings beschränkt bzw. nur mit erhöhtem Aufwand verbunden. Nachteilig ist z.B., dass die Bauteile beim Löten (beispielsweise im Lötbad) aufschwimmen. Eine dreidimensionale Anordnung von mehreren Bauteilen ist entweder gar nicht (z.B. bei PCB oder FPC) möglich, oder nur eingeschränkt bei Stanzgittern. Sind die Bauteile auf ihrem Träger (PCB, FPC oder Stanzgitter) montiert und anschließend elektrisch kontaktiert worden, erfolgt nur eine eingeschränkte Wärmeabfuhr bei Wärme erzeugenden Bauteilen.

Aus der EP 0 891 124 A2 oder der US 2001/0006859 A1 geht ein Stanzgitter mit Leitungsbereichen und Kontaktflächen zur elektrischen Kontaktierung eines Bauteiles als bekannt hervor, wobei das Stanzgitter in einem Montagebereich zur elektrischen Kontaktierung und mechanischen Festlegung des Bauteiles an dem Stanzgitter ausgebildet ist. Die Montagebereiche sind entweder als Kontaktfahnen ausgebildet, auf die ein Stecker aufgesteckt werden kann, oder zur elektrischen Kontaktierung und mechanischen Festlegung des Bauteiles schenkelförmig ausgebildet ist, um in diesem Bereich zum Beispiel eine Sicherung einsetzen zu können

Der Erfindung liegt daher die Aufgabe zu Grunde, die eingangs geschilderten Nachteile zu vermeiden, insbesondere ein Stanzgitter bereitzustellen, das größere Gestaltungsfreiheiten beim Montieren und Kontaktieren von Bauteilen bietet und gleichzeitig eine verbesserte Wärmeabfuhr und höhere Kontaktsicherheit von montierten Bauteilen und eine einfachere Montage realisiert.

Diese Aufgabe ist durch die Merkmale des Patentsanspruches 1 gelöst.

Erfindungsgemäß ist vorgesehen, dass das Stanzgitter in einem Montagebereich nicht nur zur elektrischen Kontaktierung des Bauteiles, sondern auch zur mechanischen Festlegung des Bauteiles an dem Stanzgitter ausgebildet ist.

Hierzu ist konkret vorgesehen, dass der Montagebereich korbartig und zur Ausübung einer Kraft auf das eingesetzte Bauteil ausgebildet ist, wobei weiterhin der Montagebereich an den Kontaktflächen, zumindest an einer Kontaktfläche ein Lotdepot aufweist

Daraus resultieren mehrere Vorteile. Die mechanische Festlegung des Bauteiles an dem Stanzgitter verhindert, dass dieses während des elektrischen Kontaktiervorgangs festgelegt ist, so dass es beispielsweise beim Durchführen des Stanzgitters durch ein Lötbad nicht aufschwimmen kann. Durch den engen Kontakt auf Grund der mechanischen Festlegung des Bauteiles an dem Stanzgitter kann Wärme, die von dem Bauteil während seines Betriebes erzeugt wird, ohne weiteres an das Stanzgitter abgeführt werden. Damit reduziert sich die Wahrscheinlichkeit eines Ausfalles des Bauteiles deutlich, da es thermisch nicht mehr so hoch belastet ist wie bisher.

Gemäß der Erfindung ist der Montagebereich zur mechanischen Festlegung des Bauteiles an dem Stanzgitter korbartig ausgebildet. Diese korbartige Ausgestaltung wird so gewählt, dass die Innenkontur des korbartigen Montagebereiches in etwa der Außenkontur des festzulegenden Bauteiles entspricht, so dass dieses schnell und einfach, gegebenenfalls auch automatisiert, in den Montagebereich eingesetzt werden kann. Damit das eingesetzte Bauteil in dem Montagebereich gehalten wird, ist es einerseits denkbar, dass es dort durch zusätzliche Mittel, wie z.B. einem Kleber, festgelegt wird oder andererseits, alternativ oder ergänzend denkbar, dass der Montagebereich zur Ausübung einer Kraft auf das eingesetzte Bauteil ausgebildet ist. Auf Grund der letztgenannten Möglichkeit verbleibt das Bauteil nach dem Einsetzen in dem Montagebereich durch Kraftschluss, was eine besonders einfache Möglichkeit der Festlegung des Bauteiles darstellt. Diese Möglichkeit bietet sich vor allen Dingen dann an, wenn das Bauteil automatisiert in den Montagebereich des vorgefertigten Stanzgitters eingesetzt wird.

Weiterhin weist gemäß der Erfindung der Montagebereich an seinen Kontaktflächen, innerhalb derer das Bauteil in dem Montagebereich elektrisch kontaktiert wird, ein Lotdepot auf. Das bedeutet, dass die Kontaktbereiche des Montagebereiches des Stanzgitters, welche den Korb bilden, einen Vorrat von Lotmaterial aufweisen, damit das Bauteil und das Stanzgitter mit einem entsprechenden Lötverfahren (z.B. Dampfphase, Laserlöten, Lotbad und dergleichen) sicher kontaktiert werden kann.

In Weiterbildung der Erfindung weist der Montagebereich, insbesondere der korbartige Montagebereich, aus dem Stanzgitter geformte Laschen auf. Dies hat den Vorteil, dass die bekannte Technik für das Stanzbiegeverfahren zur Herstellung des Stanzgitters genutzt werden kann, um nicht nur das Stanzgitter selber, sondern auch den Montagebereich, insbesondere den korbartigen Montagebereich, herzustellen.

In Weiterbildung der Erfindung wird das Stanzgitter mit einer Umspritzung aus einem elektrisch nicht leitfähigem Material, insbesondere einem Kunststoff, nach dem Einsetzen und Kontaktieren des Bauteiles oder gegebenenfalls der mehreren Bauteile zumindest teilweise, insbesondere vollständig (mit Ausnahme von Bereichen, mit denen eine weitere elektrische Kontaktierung erfolgt) umspritzt. Damit bildet das Stanzgitter mit den Bauteilen und Anschlussbereichen für Steckverbinder ein elektronisches Gerät, das an beliebiger einsetzbar ist. Daneben bietet das Stanzgitter den Vorteil, dass es beliebig formbar ist, vor allen Dingen nicht nur in der Fläche, sondern auch dreidimensional. Damit ermöglicht es die Erfindung, die Ausgestaltung des Stanzgitters und die Anordnung der Bauteile frei zu gestalten, wodurch es sowohl für kleine und große Rastermaße geeignet ist.

Neben der Möglichkeit, die Bauteile mit den Kontaktflächen an dem Stanzgitter durch Löten vorzunehmen, sind selbstverständlich auch andere Kontaktierungsverfahren (wie beispielsweise Ultraschall-Löten, Schweißen, Crimpen und dergleichen, ohne dass diese Aufzählung vollständig ist), denkbar. Bei den Bauteilen kann es sich um beliebige elektrische und elektronische Bauteile wie z.B. Widerstände, Kondensatoren, Spulen und dergleichen, ohne dass diese Aufzählung vollständig ist, handeln, wobei diese Bauteile bedrahtete Bauteile oder SMD-Bauteile sein können. Weiterhin bietet der Montagebereich, insbesondere der korbartige Montagebereich zur Aufnahme des Bauteiles den Vorteil, dass das Stanzgitter, insbesondere dessen Leitungsbereiche, die im Regelfall größere Flächen bieten, als Kühlkörper zwecks Wärmeabfuhr dienen. Damit können zusätzliche Maßnahmen zur Wärmeabfuhr (z.B. zusätzliche Kühlkörper oder Ventilatoren der dergleichen) entfallen.

Ausführungsbeispiele der Erfindung, auf die diese jedoch nicht beschränkt ist, sind im Folgenden beschrieben und anhand der Figuren erläutert.

Es zeigen:
- Figur 1:: ein Stanzgitter mit Montagebereich vor der Bestückung mit Bauteilen,
- Figur 2:: ein Stanzgitter nach der Bestückung mit Bauteilen,
- Figuren 3 und 4:: Detailansichten eines Montagebereiches des Stanzgitters vor und nach dem Bestücken mit Bauteilen.

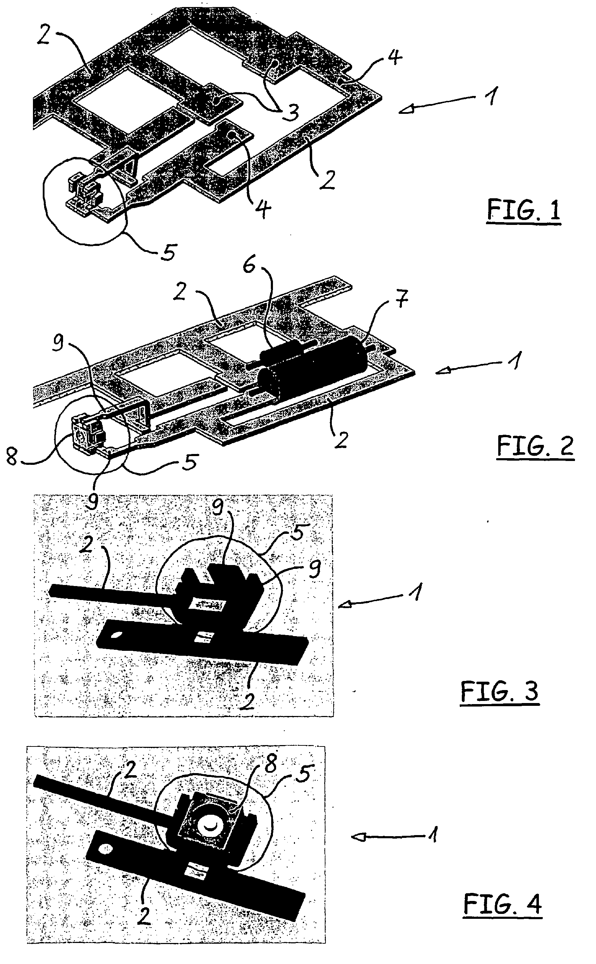

Figur 1 zeigt, soweit im Einzelnen dargestellt, ein Stanzgitter 1, das in einem Stanzbiegeverfahren hergestellt ist und Leitungsbereiche 2 zur Strom- oder Signalführung und Kontaktflächen 3, 4 zur Kontaktierung mit Bauteilen aufweist. In einem Bereich des Stanzgitters 1 ist beispielhaft ein Montagebereich 5 angeordnet, der einstückig mit dem Stanzgitter 1 hergestellt ist und je nach geometrischer Ausgestaltung des Stanzgitters 1 an der erforderlichen Stelle angeordnet werden kann. So sind beispielsweise Anordnungen von einem oder mehreren Montagebereichen 5 nicht nur an der Seite denkbar, sondern diese können auch nach oben oder unten, d.h., abweichend von der Ebene, in der sich das Stanzgitter 1 befindet, angeordnet sein. Damit unterscheidet sich das erfindungsgemäße Stanzgitter 1 vom Stand der Technik, bei dem die Leitungsbereiche 2 und die Kontaktflächen 3, 4 immer nur in einer einzigen Ebene angeordnet sind. An dieser Stelle sei noch erwähnt, dass der Montagebereich 5 zur elektrischen Kontaktierung und mechanischen Festlegung eines Bauteiles einstückig mit dem Stanzgitter 1 hergestellt wird oder alternativ separat davon hergestellt und anschließend mit dem Stanzgitter 1 verbunden wird.

Figur 2 zeigt das Stanzgitter 1 gemäß Figur 1, nachdem in herkömmlicher Weise das Stanzgitter 1 mit Bauteilen 6, 7 und in erfindungsgemäßer Weise mit einem weiteren Bauteil 8, hier als LED ausgestaltet, bestückt worden ist. Neben dieser Bestückung in herkömmlicher und erfindungsgemäßer Weise ist es selbstverständlich auch denkbar, dass das Stanzgitter 1 nur mit einem Montagebereich 5 oder auch mit mehreren Montagebereichen 5, wie sie die Erfindung vorschlägt, versehen ist und die herkömmliche Bestückung entfällt. In der Figur 2 ist erkennbar, dass aus dem Stanzgitter 1 Laschen 9 herausgebildet sind, die sowohl die Strom- oder Signalzufuhr bzw. Ableitung zu dem dort eingesetzten Bauteil 8 bilden, als auch das Bauteil 8 in diesem Montagebereich 5 mechanisch festlegen. Die Laschen 9 haben den Vorteil, dass sie so gebogen werden können, dass sie einen Druck auf das einzusetzende Bauteil 8 ausüben, damit es vor dem Kontaktierungsvorgang, insbesondere vor dem Lötvorgang, festgelegt und während des Lötvorganges dort sicher gehalten wird. Außerdem können die Endbereiche der Laschen 9 vor dem Einsetzen des Bauteiles 8 mit einem Lötdepot versehen werden, das während des Kontaktierungsvorganges schmilzt und damit die elektrische Kontaktierung des Bauteiles 8 über die Laschen 9 mit den Leitungsbereichen 2 des Stanzgitters 1 herstellt. Alternativ oder ergänzend dazu kann ein Lötdepot auch an dem Bauteil 8 vorgesehen werden.

Die Figuren 3 und 4 zeigen eine alternative korbartige Ausgestaltung des Montagebereiches 5, wobei bei diesem Ausführungsbeispiel insgesamt vier Laschen 9 vorhanden sind, wobei die Anordnung der mehr als zwei Laschen 9 so gewählt ist, dass sie das einzusetzende Bauteil 8 teilweise umschließen. Bei dem Ausführungsbeispiel gemäß Figur 3 und 4 ist das einzusetzende und zu kontaktierende Bauteil 8 eine LED in SMD-Bauweise, wobei zwei gegenüberliegende Laschen 9 der elektrischen Kontaktierung (und gegebenenfalls der mechanischen Festlegung) dienen, während die beiden anderen gegenüberliegenden Laschen 9 nur die Funktion der mechanischen Festlegung, nicht aber der elektrischen Kontaktierung dienen. Bezüglich des in den Figuren 3 und 4 gezeigten Ausführungsbeispieles sei noch darauf hingewiesen, dass die Leitungsbereiche 2 des Stanzgitters 1 auch als Kontaktpartner, hier als Kontaktstifte ausgebildet sein können, die mit einem zugehörigen Steckverbindungspartner, hier als nicht dargestellte Buchse, zusammengesteckt werden können. Gleiches gilt für den Montagebereich 5, der entweder ein als Kontaktpartner (Stecker- oder Buchsenelement) ausgebildetes Bauteil aufnimmt oder als solches selber ausgebildet ist.

### Bezugszeichenliste

- 1.: Stanzgitter
- 2.: Leitungsbereiche
- 3.: Kontaktflächen
- 4.: Kontaktflächen
- 5.: Montagebereich
- 6.: Bauteil
- 7.: Bauteil
- 8.: Bauteil
- 9.: Laschen

## Patentansprüche

1. Stanzgitter (1) mit Leitungsbereichen (2) und Kontaktflächen (3, 4) zur elektrischen Kontaktierung eines Bauteiles (6, 7, 8), wobei das Stanzgitter (1) in einem Montagebereich (5) zur elektrischen Kontaktierung und mechanischen Festlegung des Bauteiles (8) an dem Stanzgitter (1) ausgebildet ist, **dadurch gekennzeichnet, dass** der Montagebereich (5) korbartig und zur Ausübung einer Kraft auf das eingesetzte Bauteil (8) ausgebildet ist, wobei weiterhin der Montagebereich (5) an den Kontaktflächen, zumindest an einer Kontaktfläche ein Lotdepot aufweist.

2. Stanzgitter (1) nach Anspruch 1, **dadurch gekennzeichnet, dass** der Montagebereich (5), insbesondere der korbartige Montagebereich, aus dem Stanzgitter (1) geformte Laschen (9) aufweist.

3. Stanzgitter (1) nach Anspruch 2, **dadurch gekennzeichnet, dass** die Laschen (9) in einem Stanzbiegeverfahren herstellbar sind.

4. Stanzgitter (1) nach Anspruch 2 oder 3, **dadurch gekennzeichnet, dass** die Laschen (9) einen Kontaktpartner einer Steckverbindung bilden.

5. Stanzgitter (1) nach einem der vorhergehenden Ansprüche, **gekennzeichnet durch** eine Umspritzung aus einem elektrisch nicht leitfähigem Material, insbesondere einem Kunststoff.

## Claims

1. Leadframe (1) having conductive regions (2) and contact areas (3, 4) for making electrical contact with a component (6, 7, 8), where the leadframe (1) has a mounting region (5) designed for making electrical contact with and mechanically fixing the component (8) on the leadframe (1), **characterized in that** the mounting region (5) is basket-like and designed to exert a force on the inserted component (8), and the mounting region (5) also has a solder deposit on the contact areas, at least on one contact area.

2. Leadframe (1) according to Claim 1, **characterized in that** the mounting region (5), particularly the basket-like mounting region, has links (9) formed from the leadframe (1).

3. Leadframe (1) according to Claim 2, **characterized in that** the links (9) can be produced using a stamping and bending process.

4. Leadframe (1) according to Claim 2 or 3, **characterized in that** the links (9) form an opposite contact in a plug connection.

5. Leadframe (1) according to one of the preceding claims, **characterized by** extrusion coating using an electrically nonconductive material, particularly a plastic.

## Revendications

1. Réseau de barres conductrices (1) avec des zones conductrices (2) et des surfaces de contact (3, 4) pour assurer le contact électrique d'un composant (6, 7, 8), le réseau de barres conductrices (1) étant réalisé dans une zone de montage (5) pour assurer le contact électrique et la fixation mécanique du composant (8) sur le réseau de barres conductrices (1), **caractérisé en ce que** la zone de montage (5) est réalisée sous forme de panier et de manière à exercer une force sur le composant inséré (8), la zone de montage (5) présentant en outre sur les surfaces de contact, et au moins sur une surface de contact, un dépôt de brasure.

2. Réseau de barres conductrices (1) selon la revendication 1, **caractérisé en ce que** la zone de montage (5), notamment la zone de montage en forme de panier, présente des pattes (9) formées dans le réseau de barres conductrices (1).

3. Réseau de barres conductrices (1) selon la revendication 2, **caractérisé en ce que** les pattes (9) peuvent être fabriquées par un procédé d'estampage-cintrage.

4. Réseau de barres conductrices (1) selon la revendication 2 ou 3, **caractérisé en ce que** les pattes (9) forment un partenaire de contact d'une connexion à fiches.

5. Réseau de barres conductrices (1) selon l'une quelconque des revendications précédentes, **caractérisé par** un surmoulage constitué d'un matériau non conducteur de l'électricité, notamment une matière plastique.
